# EUROPEAN PATENT SPECIFICATION

(11) **EP 0 849 984 B1**
(45) Date of publication and mention of the grant of the patent: **17.02.1999**
(21) Application number: 96830634.0
(22) Date of filing: 18.12.1996
(51) Int. Cl.: H05K 5/00, H02B 1/30

(54) **A modular cabinet**
Modularer Schaltschrank
Armoire modulaire

(43) Date of publication of application: 24.06.1998
(73) Proprietor: E.T.A. S.p.A., 22035 Canzo (Como) (IT)
(72) Inventor: Turati, Aldo, 22030 Caslino d'Erba (Como) (IT)
(74) Representative: Sutto, Luca

(56) References cited:
- DE-U- 9 301 698
- US-A- 3 056 639
- US-A- 3 378 320
- US-A- 4 179 169
- US-A- 4 836 626

## Description

The present invention relates to a modular cabinet, particularly arranged for housing electric and electronic apparatuses.

It is known that presently available cabinets arranged for the above described uses consist of a fixed framework generally made of a metal material and having a substantially parallelepiped conformation. Such a fixed framework, provided or not with lateral covering panels needs to be each time modified and provided with attachments or supporting elements enabling direct employment of brackets, closing panels, closing leaves or doors, shelves or other components that may be each time required and serve as the cabinet's front finish or are to be used for conveniently housing/supporting the apparatuses for which the cabinet is intended.

By way of example, should the cabinet be intended for housing an electric board optionally provided with a keyboard for entering data or with output members such as display monitors and/or printers, said cabinet will have to be made so as to be able to hold and support said component members and will also be provided with frontal access doors, if necessary.

In conclusion, since accessories to be housed in metal cabinets can be of the most different types, said cabinets need to be modified each time so that they may be able to conveniently house all components that are introduced thereinto or associated therewith.

Obviously, the above gives rise to many drawbacks.

First of all, from a construction point of view, it is necessary to arrange as many fixed frameworks as are the actual possible uses of said cabinets, because practically, each fixed framework will be different depending on the provided application.

As regards the cabinet assembling too, it is to note that since the attachment elements or engagement portions that are to be arranged on the fixed framework need to be different each time depending on requirements, important losses of time are involved and, as a result, heavier costs for manpower.

It is also important to note that presently used cabinets have a poor operating versatility, as they cannot be converted with ease from one employment to another, due to the great number of parts to be replaced each time and consequently the plurality of disassembling and assembling steps necessarily required.

Still as regards installation of said cabinets, it is to point out that cabinets presently available on the market must be either previously assembled at the factory, which will involve a great bulkiness during transportation, or directly mounted by a user who necessarily must have a sufficient technical knowledge and good capabilities for carrying out the assembling operations in the intended time and following appropriate modalities.

It is also known from document US-A-3378320 a modular constructed enclosure for mounting equipment therein in which a main frame is designed to receive a slant front module. The slant front module can be assembled in different positions on the main frame and may be employed as a console having a front panel carrying instruments and controls.

Under this situation, the present invention aims at substantially eliminating all the above mentioned drawbacks.

In particular, it is a fundamental object of the invention to provide a new modular cabinet that is capable of ensuring a great versatility and wide possibilities of use, while at the same time employing the lowest possible number of components.

Another object of the invention is to provide a modular cabinet which can be easily assembled by a final user too and also converted to several different applications by substantially replacing a single component.

A still further fundamental object of the invention is to provide a modular cabinet affording a reduced bulkiness during transportation.

The foregoing and other objects that will become more apparent in the progress of the present description are substantially achieved by a modular cabinet as disclosed in the appended claims.

Further features and advantages will best be understood from the detailed description of some preferred but non-exclusive embodiments of a modular cabinet in accordance with the invention, taken hereinafter with reference to the accompanying drawings, in which:
- Figs. 1 and 2 are perspective views of possible versions of a supporting framework being part of a modular cabinet in accordance with the invention;
- Fig. 3 is a perspective view of an auxiliary framework adapted to be associated with the supporting frameworks shown in Figs. 1 and 2;
- Figs. 4 to 8 show the auxiliary framework of Fig. 3 equipped with several different operating elements such as doors, closing leaves, brackets, shelves, etc.
- Fig. 9 is a perspective view showing a possible alternative version of an auxiliary framework to be associated with the supporting frameworks shown in Figs. 1 and 2;
- Fig. 10 is a diagrammatic sectional view showing coupling between the auxiliary framework represented in Fig. 3 and one of the supporting frameworks illustrated in Figs. 1 and 2;

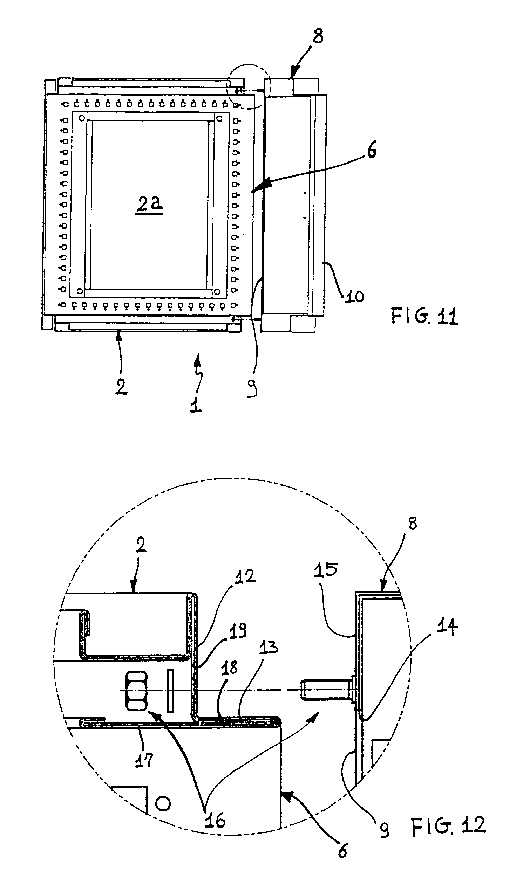

- Fig. 11 is a sectional view taken along line XI-XI in Fig. 10; and
- Fig. 12 is an enlarged view of a detail shown in Fig. 11.

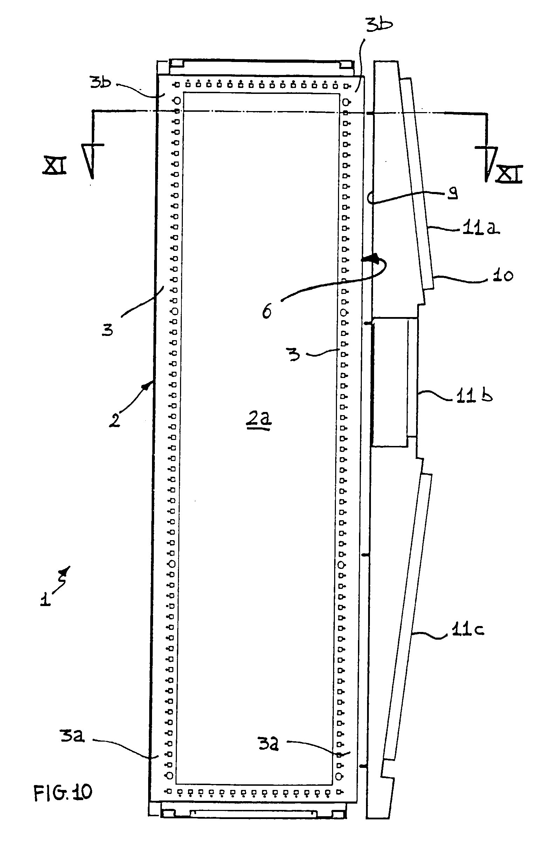

With reference to the drawings and in particular to Fig. 10, a modular cabinet in accordance with the present invention has been generally identified by reference numeral 1.

The modular cabinet 1 comprises a supporting framework 2 of a box-shaped conformation, defining a wide housing 2a, herein in the form of a parallelepiped, inside which the different components and apparatuses to be contained in the cabinet can be received.

In particular, the modular cabinet in reference preferably lends itself to be used for housing electric boards, electronic components, output members such as printers, display monitors, peripherals of different types, input members such as keyboards, mouses or others, depending on requirements.

The supporting framework 2 comprises vertical posts 3 connected at a first end 3a, to a lower base 4 and, at a second end 3b, to an upper base 5.

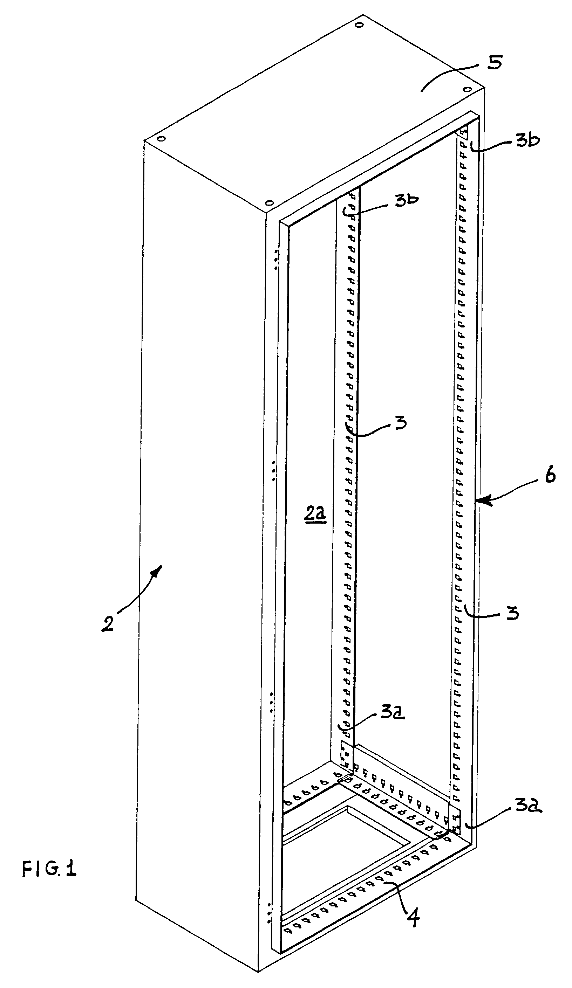

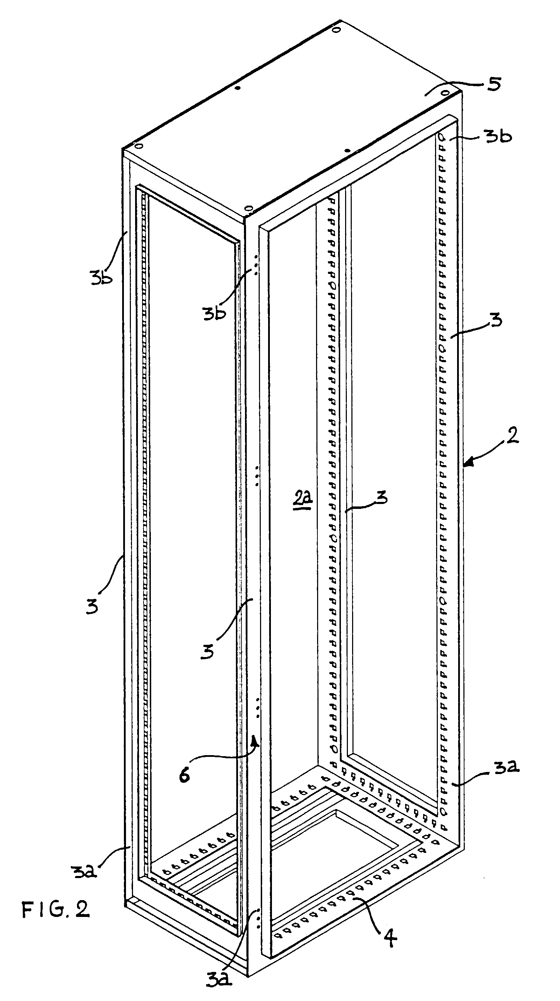

Depending on requirements, the supporting framework 2 will have an open structure, as shown in Fig. 2, or will be provided with side panels, as shown in Fig. 1.

Preferably and advantageously, the post ends 3a, 3b are connected by removable tightening to bases 4 and 5, by means of threaded members for example, in order to enable the supporting framework 2 to be disassembled and therefore to be easily transported due to its minimum bulkiness.

Alternatively, said posts 3 could be welded at their ends to the lower and upper bases 4, 5, which however would make transportation of the supporting framework, and consequently of the modular cabinet taken as a whole, much more difficult.

The supporting framework 2 also has a front wall 6 with which a given number of operating elements 7 may be associated. By way of example, said operating elements 7 may be doors, shelves, brackets or others, depending on the particular use intended for the cabinet.

In an original manner and in accordance with the invention, the modular cabinet 1 comprises an auxiliary framework 8 operatively interposed between the supporting framework and the operating elements. The auxiliary framework has a first portion 9 joined to the front wall 6 of the supporting framework 2, and a second portion 10 defining engagement housings 11a, 11b, 11c for said operating elements. As shown in the accompanying figures, the shape of the first portion 9 of the auxiliary framework 8 substantially matches that of the front wall 6 of the supporting framework 2 and is intended for coupling therewith.

In turn, the supporting-framework front wall 6 comprises a perimetric frame 12, completely extending in a vertical lying plane, and an engaging projection 13 emerging frontally from the perimetric frame. The engaging projection 13 is arranged for coupling with a corresponding seating 14 formed on a front edge 15 of the first auxiliary framework portion.

As shown in the enlarged view of Fig. 12, removable tightening means 16 is provided which consists of threaded members for example, which are operatively interposed between the perimetric frame 12 of the supporting framework and the front edge 15 of the auxiliary framework, so as to make it possible for the auxiliary framework to be engaged with and disengaged from the fixed framework. The foregoing enables the different types of auxiliary frameworks to be engaged by turns, if desired, with the same supporting framework by means of simple and quick disassembling and reassembling operations.

From a manufacturing point of view, it is to note that the different posts 3 forming the supporting framework 2, and consequently the perimetric frame 12 and engaging projection 13, are defined by bent portions of section members consecutively interconnected. This, in terms of production, is very efficient in that it can be achieved at high production rates and with reduced costs.

More particularly, each post 3 of the fixed framework is comprised of at least one first portion 17 to which a second portion 18 bent at 180° relative to said first portion is consecutively connected so as to define the engaging projection 13, followed by a third portion 19 disposed consecutively of said second portion and bent at 90° relative to the second portion itself, so as to define the perimetric frame 12 (see Fig. 12 again).

Advantageously, it is to point out that due to the presence of the auxiliary framework 8, the latter can be given a predetermined dimension in thickness so that collecting spaces 20 available for users are defined at at least one of the engagement housings 11a, 11b, 11c intended for receiving the operating elements 7.

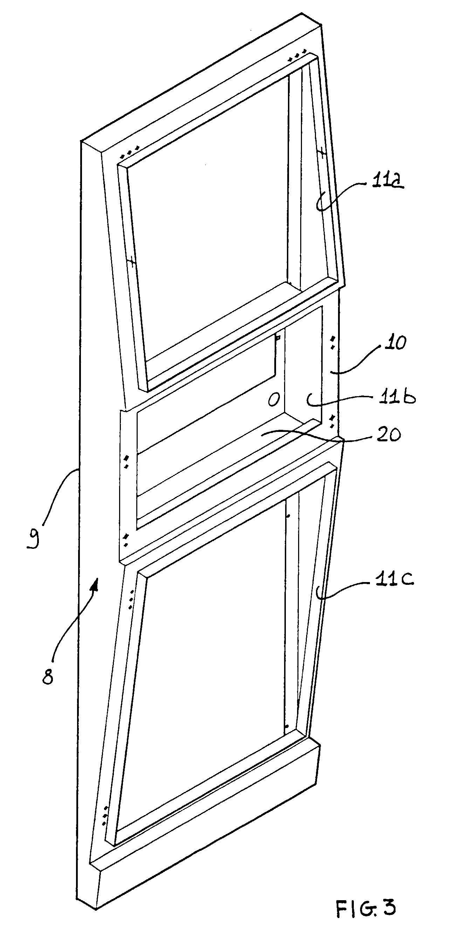

In particular, Fig. 3 shows a possible embodiment of the auxiliary framework. It comprises first, second and third engagement housings, 11a , 11b and 11c respectively, disposed consecutively on top of each other.

In this case, provided at the second housing 11b located in the middle is a collecting space 20 of transverse dimensions substantially corresponding to the thickness of the auxiliary framework 8.

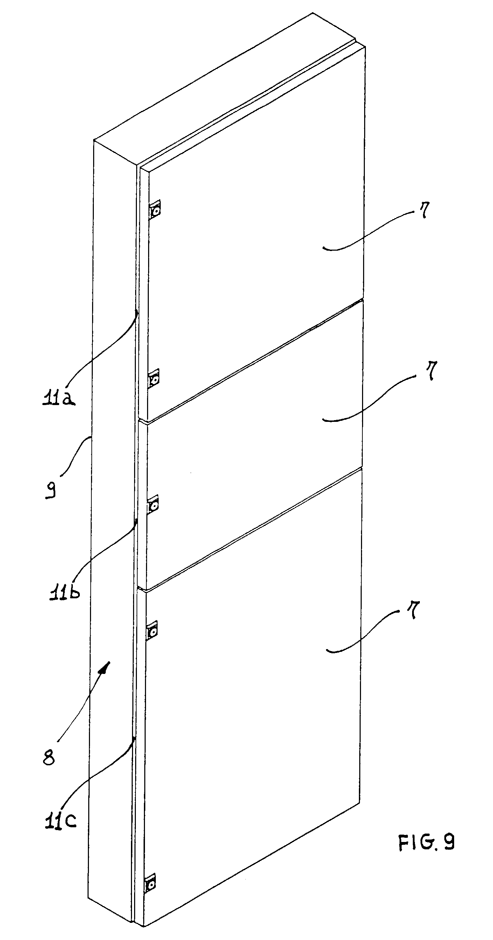

Obviously, should the auxiliary framework be made in accordance with the solution shown in Fig. 9, a collecting space 20 could be provided at each of the above mentioned three housings.

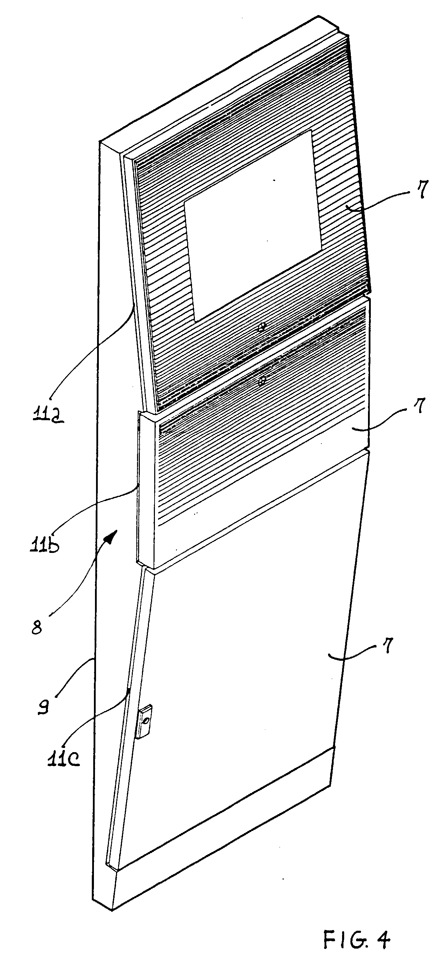

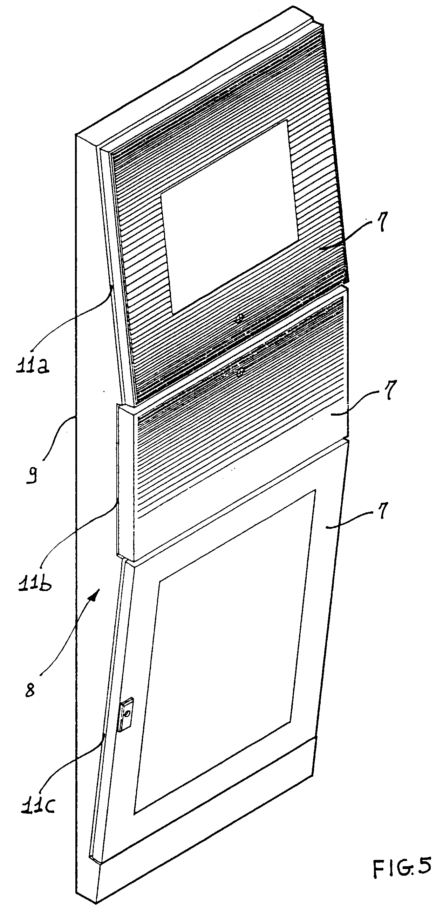

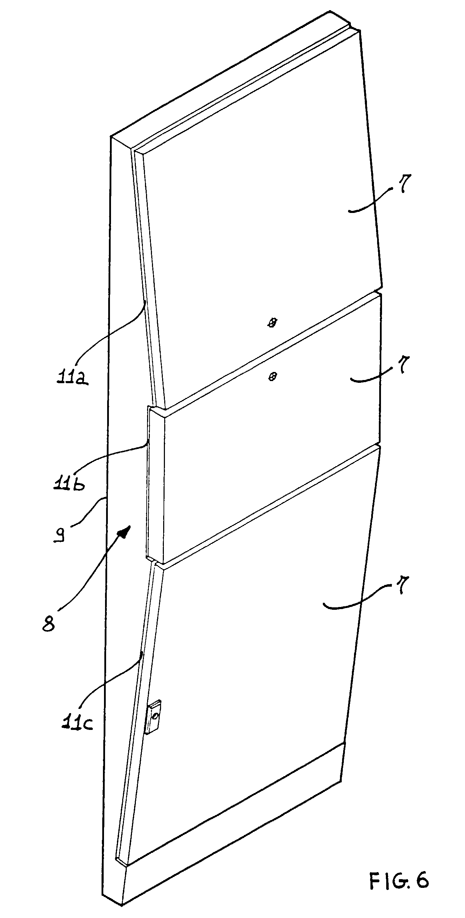

In more detail and as regards the possible conformations of the auxiliary framework, it is to note that the latter can exactly define one, two or more than two housings 11a, 11b, 11c intended for receiving respective operating elements 7, depending on requirements. In the examples shown the represented auxiliary frameworks always have three housings in which the first engagement housing 11a located at the top is intended for receiving a first operating element 7 consisting of a door element which can be blind (Figs. 6 and 9) or provided with a transparent window (Figs. 4, 5, 7 and 8).

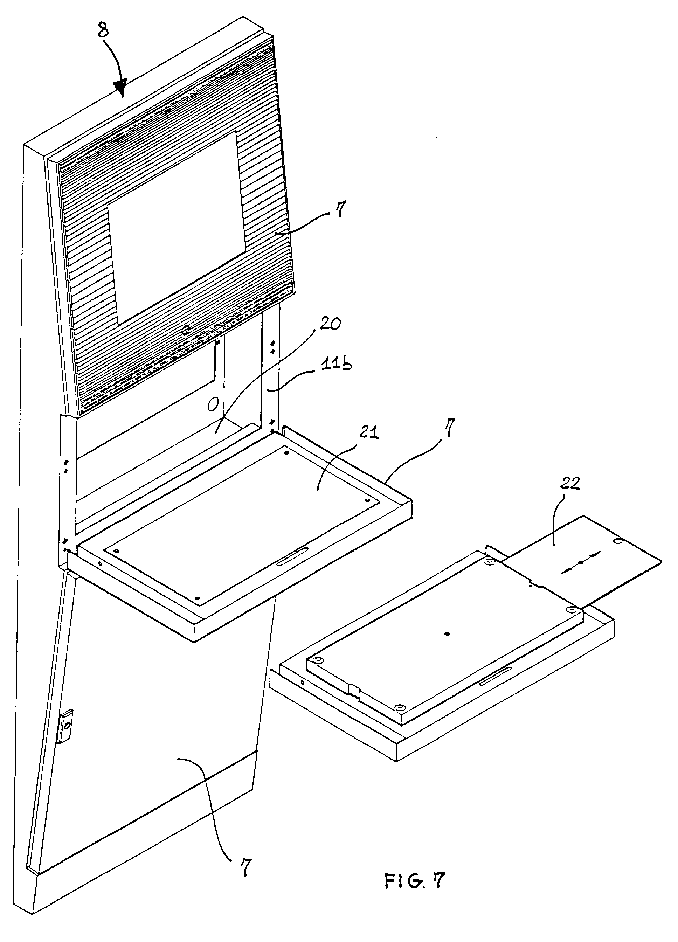

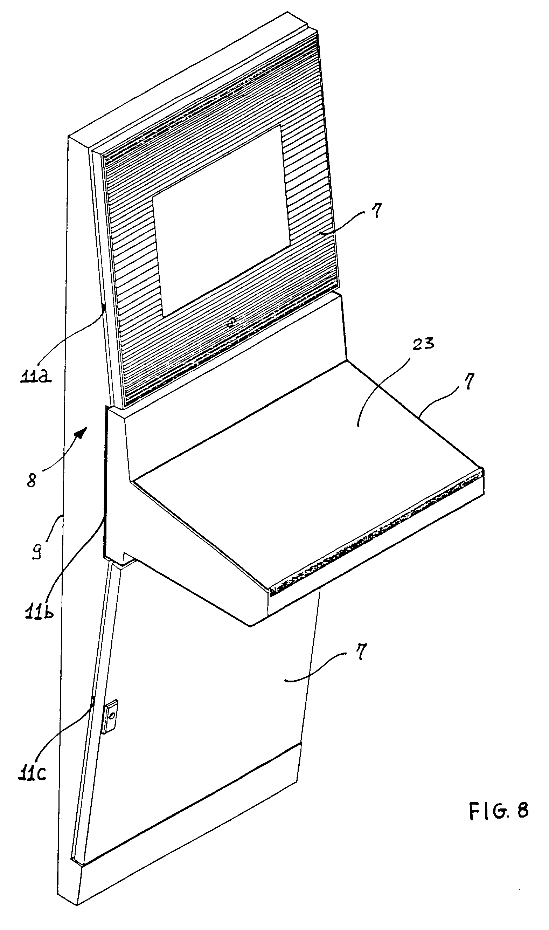

The second engagement housing 11b, located in the middle, may be provided with an operating element defined either by a door or a swinging shelf 21 movable about a horizontal axis (see Fig. 7) optionally provided with a panel 22 movable transversely of the swinging shelf, or by a fixed shelf 23 (see Fig. 8).

Finally, the third engagement housing 11c, located at the bottom, may consist of a door element too, or other components depending on requirements.

The invention achieves important advantages.

First of all, due to the presence of the auxiliary framework 8, the operating functionality of one and the same fixed framework can be modified by exclusively replacing the auxiliary framework.

As a result of the above, a great versatility of use is ensured and modifications, the accomplishment of which has been hitherto impossible, can be now carried out without difficulty.

It is to note that, due the great ease with which the functional use of a cabinet can be modified, a final user too is in a position to easily carry out the necessary modifying operations without any particular equipment or know-how.

In other words, the modular character of the cabinet in accordance with the invention is developed at the front and therefore it is possible to modify its final functional use by replacing a minimum number of components that, on the other hand, can be previously assembled at the factory (auxiliary framework + operating elements), so as to comply with the most different requirements.

Finally, as regards the possibility of saving room at the transportation time, it is to note that the overall dimensions of the packed modular cabinet in accordance with the invention are minimum, above all in the version providing posts susceptible of being separated from the respective bases, and therefore it can be easily transported.

Obviously, many modifications and variations may be made to the invention as conceived, all of them falling within the scope of the appended claims.

## Claims

1. A modular cabinet comprising:
- a supporting framework (2) of a box-shaped conformation,
- a predetermined number of operating elements (7) intended for being associated with the supporting framework, and
- an auxiliary framework (8) operatively interposed between the supporting framework (2) and the operating elements (7), said auxiliary framework (8) consisting of a first portion (9) in engagement with a front wall (6) of the supporting framework (2), and a second portion (10) defining engagement housings (11a; 11b; 11c) for said operating elements, characterized in that the shape of the first portion (9) of the auxiliary framework (8) substantially matches of the front wall (6) and in that the front wall of the supporting framework (2) comprises a perimetric frame (12) and an engaging projection (13) emerging frontally from said perimetric frame and designed to be coupled with a corresponding seating (14) formed in a front edge (15) of said first portion (9).

2. A modular cabinet according to claim 1, characterized in that it comprises removable tightening means (16) operatively interposed between said perimetric frame (12) and frontal edge (15).

3. A modular cabinet according to claim 1, characterized in that said supporting framework (2) comprises vertical posts (3) connected, at one end (3a), to a lower base (4) and, at a second end (3b), to an upper base (5).

4. A modular cabinet according to claim 3, characterized in that each post comprises at least one first portion (17) to which a second portion (18) bent at 180° relative to said first portion is consecutively connected so as to define the projection (13), followed by a third portion (19) disposed consecutively of said second portion and bent at 90° relative to the second portion itself, so as to define a part of the perimetric frame (12).

5. A modular cabinet according to claim 1, characterized in that the ends (3a, 3b) of said posts (3) are connected to said bases (4, 5) by welding or removable tightening.

6. A modular cabinet according to claim 1, characterized in that said auxiliary framework (8) has a predetermined dimension in thickness so as to define collecting spaces (20) at at least one of said engagement housings (11a, 11b, 11c).

7. A modular cabinet according to claim 1, characterized in that said engagement housings comprise at least one first (11a), one second (11b) and one third housing (11c) arranged to engage a first, a second and a third operating element (17), respectively.

8. A modular cabinet according to claim 1, characterized in that said first operating element and third operating element comprise respective door elements.

9. A modular cabinet according to claim 7, characterized in that said second operating element comprises either a fixed shelf (23) or a swinging shelf (21) movable about a horizontal axis.

## Patentansprüche

1. Modularer Schaltschrank, umfassend,
- einen Tragrahmen (2) mit kastenförmiger Ausbildung,
- eine vorgegebene Anzahl von Eingriffselementen (7), die dazu bestimmt sind, dem Tragrahmen zugeordnet zu werden, und
- einen Hilfsrahmen (8), der wirksam zwischen dem Tragrahmen (2) und den Eingriffselementen (7) geschaltet ist, wobei der Tragrahmen (2) aus einem ersten, an einer Stirnwand (6) des Tragrahmens (2) angreifenden Teil (9) und aus einem zweiten Teil (10) besteht, das die Eingriffsaufnahmen (11a; 11b; 11c) für die Eingriffselemente festlegt, **dadurch gekennzeichnet,** daß die Form des ersten Teils (9) des Hilfsrahmens (8) zu jener der Stirnwand (6) gegenprofiliert ist, und **dadurch**, daß die Stirnwand des Tragrahmens (2) eine umlaufende Einfassung (12) und einen Eingriffsansatz (13) umfaßt, der stirnseitig von der umlaufenden Einfassung vorsteht und dazu ausgelegt ist, mit einer entsprechenden Aufnahme (14) in Eingriff gebracht zu werden, die am Stirnrand (15) des ersten Teils (9) ausgenommen ist.

2. Modularer Schaltschrank nach Anspruch 1, **dadurch gekennzeichnet,** daß er abnehmbare Spannmittel (16) umfaßt, die wirksam zwischen der umlaufenden Einfassung (12) und dem Stirnrand (15) geschaltet sind.

3. Modularer Schaltschrank nach Anspruch 1, **dadurch gekennzeichnet,** daß der Tragrahmen (2) senkrechte Ständer (3) umfaßt, die an einem Ende (3a) mit einer unteren Basis (4) und an einem zweiten Ende (3b) mit einer oberen Basis (5) verbunden sind.

4. Modularer Schaltschrank nach Anspruch 3, **dadurch gekennzeichnet,** daß jeder Ständer mindestens ein erstes Teil (17), mit dem ein zweites zur Festlegung des Eingriffsansatzes (13) um 180° gegenüber dem ersten Teil abgebogenes Teil (18) verbunden ist, und ein drittes, an jenem ersten anschließendes Teil (19), das gegenüber diesem letzteren um 90° zur Festlegung eines Teils der umlaufenden Einrahmung (12) abgekantet ist.

5. Modularer Schaltschrank nach Anspruch 1, **dadurch gekennzeichnet,** daß die Enden (3a, 3b) der Ständer (3) über Verschweissung bzw. einen lösbaren Eingriff verbunden sind.

6. Modularer Schaltschrank nach Anspruch 1, **dadurch gekennzeichnet,** daß der Hilfsrahmen (8) eine vorgegebene Dickenabmessung aufweist, um im Bereich mindestens einer der Eingriffsaufnahmen (11a, 11b, 11c) Auffanglücken (20) festzulegen.

7. Modularer Schaltschrank nach Anspruch 1, **dadurch gekennzeichnet,** daß die Eingriffsaufnahmen mindestens eine erste (11a), eine zweite (11b) und eine dritte Aufnahme (11c) umfassen, die jeweils ein erstes, ein zweites und ein drittes Eingriffselement (17) erfassen können.

8. Modularer Schaltschrank nach Anspruch 1, **dadurch gekennzeichnet,** daß das erste Eingriffselement und das zweite Eingriffselement jeweilige Flügelelemente umfassen.

9. Modularer Schaltschrank nach Anspruch 7, **dadurch gekenzeichnet**, daß das zweite Eingriffselement ein erstes, feststehendes Schrankbrett (23) oder ein um eine horizontale Achse verschwenkbares Schrankbrett (21) umfaßt.

## Revendications

1. Armoire modulaire comprenant:
- un bâti support (2) en forme de boîtier,
- un nombre prédéterminé d'éléments fonctionnels (7) destinés à être associés au bâti support, et
- un bâti auxiliaire (8) interposé de manière opérationnelle entre le bâti support (2) et les éléments fonctionnels (7), ledit bâti auxiliaire (8) se composant d'une première portion (9) en engagement avec une paroi de face (6) du bâti support (2), et une deuxième portion (10) définissant des logements d'engagement (11a; 11b; 11c) pour lesdits éléments fonctionnels, caractérisé en ce que la forme de la première portion (9) du bâti auxiliaire (8) épouse essentiellement celle de la paroi de face (6) et en ce que la paroi de face du bâti support (2) comporte un cadre périmétral et un ressaut d'engagement (13) faisant saillie de la partie de face dudit cadre et destiné à être couplé à un siège correspondant (14) formé dans un bord de face (15) de ladite première portion (9).

2. Armoire modulaire selon la revendication 1, caractérisé en ce qu'il comporte.des moyens de serrage amovible (16) interposés de manière opérationnelle entre ledit cadre périmétral (12) et le bord de face (15).

3. Armoire modulaire selon la revendication 1, caractérisé en ce que ledit bâti support (2) comporte des montants verticaux (3) reliés par l'une (3a) de leurs extrémités à une base inférieure (4) et par l'autre extrémité (3b) à une base supérieure (5).

4. Armoire modulaire selon la revendication 3, caractérisé en ce que chaque montant comporte au moins une première portion (17) à laquelle est reliée de manière consécutive une deuxième portion (18) pliée à 180° par rapport à ladite première portion, de manière à définir le ressaut (13), suivie d'une troisième portion (19) disposée consécutive à ladite deuxième portion et pliée à 90° par rapport a cette deuxième portion, de manière à définir une partie du cadre périmétral (12).

5. Armoire modulaire selon la revendication 1, caractérisé en ce que les extrémités (3a, 3b) desdits montants (3) sont reliées auxdites bases (4, 5) par soudage ou serrage amovible.

6. Armoire modulaire selon la revendication 1, caractérisé en ce que ledit bâti auxiliaire (8) a une dimension prédéterminée en épaisseur, de manière à définir des espaces de collecte (20) en correspondance de l'un au moins desdits logements d'engagement (11a, 11b, 11c).

7. Armoire modulaire selon la revendication 1, caractérisé en ce que lesdits logements d'engagement comportent au moins un premier (11a), un deuxième (11b) et un troisième (11c) engagements destinés à engager respectivement un premier, un deuxième et un troisième éléments fonctionnels (17).

8. Armoire modulaire selon la revendication 1, caractérisé en ce que lesdits premier élément fonctionnel et troisième élément fonctionnel comportent des éléments respectifs formant porte.

9. Armoire modulaire selon la revendication 7, caractérisé en ce que ledit deuxième élément fonctionnel comporte un rayon fixe (23) ou un rayon pivotant (21) mobile autour d'un axe horizontal.
